# EUROPÄISCHE PATENTSCHRIFT

(11) **EP 0 772 300 B1**
(45) Veröffentlichungstag und Bekanntmachung des Hinweises auf die Patenterteilung: **11.08.2004**
(21) Anmeldenummer: 96116721.0
(22) Anmeldetag: 17.10.1996
(51) Int. Cl.: H03K 17/96, G01R 19/165

(54) **Verfahren zur Umwandlung von, insbesondere zueinander amplitudendifferenten, EIN/AUS-Analogsignalen in entsprechende EIN/AUS-Digitalsignale**
Method for converting IN/OUT analog signals, in particular having different relative amplitudes to corresponding IN/OUT digital signals
Procédé de conversion de signaux analogiques d'entrée/sortie, en particulier ayant différentes amplitudes relatives, en signaux d'entrée/sortie numériques correspondants

(30) Priorität: 30.10.1995 DE 19540835
(43) Veröffentlichungstag der Anmeldung: 07.05.1997
(73) Patentinhaber: BSH Bosch und Siemens Hausgeräte GmbH, 81739 München (DE)
(72) Erfinder: Gay, Thomas, 89160 Dornstadt (DE); Menten, Frank, 93055 Regensburg (AU)

(56) Entgegenhaltungen:
- EP-A- 0 551 240
- EP-A- 0 621 460
- DE-A- 2 658 080
- FR-A- 2 561 049
- US-A- 4 433 256

## Beschreibung

Verfahren zur Umwandlung von, insbesondere zueinander amplitudendifferenten, EIN/AUS-Analogsignalen in entsprechende EIN/AUS-Digitalsignale

Die Erfindung bezieht sich auf ein Verfahren zur Umwandlung von, insbesondere zueinander amplitudendifferenten, EIN/AUS-Analogsignalen in entsprechende EIN/AUS-Digitalsignale gemäß Patentanspruch 1.

Zur Betätigung von Schaltvorgängen ist es in der Industrie oftmals notwendig, eingangsseitigen analogen Signalen ausgangsseitig digitale Signale mit einer Zustandserkennung "EIN" bzw. "AUS" zuordnen zu können. Dazu werden üblicherweise Komparatoren, insbesondere Amplitudenentscheider, herangezogen, welche die analogen Eingangssignale mit einem festen EIN-Schwellwert bzw. festen AUS-Schwellwert vergleichen und bei Erreichen dieser Schwellwerte die Zuordnung "EIN" bzw. "AUS" als jeweils entsprechendes digitales Ausgangssignal weitergegeben. Ein bevorzugtes praktisches Anwendungsbeispiel kann in der Bedienung einer elektronischen Kochstellensteuerung gesehen werden, bei der mehrere Betätigungsvorrichtungen in Form von Tastenelementen aus berührungsempfindlichen Infrarot-Reflexlichtschranken bestehen, die bei Vorhandensein einer Mindestreflexion ein EIN-Analogsignal und bei nichtvorhandener Mindestreflexion ein AUS-Analogsignal abgeben, das dann als verarbeitetes digitales Ausgangssignal "EIN" bzw. Ausgangssignal "AUS" in einem Controller zur Ansteuerung der Kochstellen dient.

Das vorbeschriebene Ansteuerungsverfahren setzt voraus, daß die dem Komparator vorgegebenen festen Schwellen in jedem Fall innerhalb des Signalhubs der EIN-Analogsignale bzw. der AUS-Analogsignale liegen und dazu bekannt sind.

Aus DE 26 58 080 A ist ein Impulsregenerator zur Erzeugung definierter Impulse aus mit Störungen überlagerten Signalen bekannt, wobei ein Differenzverstärker als Komparator und Kippspannungserzeuger dient und vor dem Differenzverstärker ein Netzwerk zur Verhinderung der Eingangsübersteuerung vorgesehen ist.

Aus US 4 433 256 A ist eine Begrenzungsschaltung oder ein Nulldurchgang-Detektor bekannt, die eine analoge Eingangswellenform in eine binäre digitale Wellenform umwandeln, so dass diese für einen Signalprozessor geeignet ist.

Aus EP 0 621 460 A1 ist eine Sensorsignalverarbeitungseinheit bekannt, insbesondere zur Detektion von Magnetismus als ein elektrisches Signal und die Digitalisierung dieses Signals. Die Sensorsignalverarbeitungseinheit weist eine Spitzenhalteeinrichtung zum Halten des Spitzenwertes der Ausgangssignale aus dem Sensor, eine Tiefenhalteeinrichtung zum Halten des Tiefstwerts der Ausgangssignale aus dem Sensor, eine Schwellwerteinstelleinrichtung zum Einstellen des Schwellwerts aus dem Spitzenwert und dem Tiefstwert und eine Vergleichseinrichtung zum Vergleichen des Ausgangssignals des Sensors mit dem Schwellwert und zum Ausgeben eines binären Signals in Übereinstimmung mit ihrer Differenz auf.

Gemäß Aufgabe vorliegender Erfindung soll trotz der bei der Herstellung eines Serienproduktes hinzunehmenden Streuung der eingangsseitigen analogen Signalwerte insbesondere aufgrund von Bauteil- und Einbautoleranzen und trotz der über einen längeren Betriebseinsatz hinzunehmenden Streuung der eingangsseitigen analogen Signalwerte insbesondere aufgrund von Temperatur- und Alterungseinflüssen auf einfache Weise und ohne Notwendigkeit einer servicebedingten Justierung die sichere Erkennung eines korrespondierenden ausgangsseitigen digitalen EIN-Signals bzw. AUS-Signals gewährleistet werden können. Die Lösung dieser Aufgabe gelingt durch ein Verfahren gemäß Patentanspruch 1; vorteilhafte Ausgestaltungen der Erfindung sind jeweils Gegenstand der Unteransprüche.

Durch die Zuordnung eines jeweils spezifischen Referenzschwellwertes für das EIN-Analogsignal bzw. das AUS-Analogsignal einer jeden zur Abgabe derartiger Signale vorgesehenen Betätigungsvorrichtung bei gewährleistetem gegenseitigen Störabstand der Referenzschwellwerte und durch die Nachführabhängigkeit dieser Referenzschwellwerte von den aufgrund der vorgenannten Einflüsse sich gegebenenfalls ändernden absoluten Werte der EIN/AUS-Analogsignale ist eine relative Erkennung und Bewertung und die selbsttätige Anpassung der Erkennungsgrenzen derart gewährleistet,daß Einflüsse wie Bauteilestreuungen, Temperatureinflüsse, Alterung, mechanische Einbautoleranzen sowie von Schwankungen, die sich durch unterschiedliche Handhabung der Betätigungsvorrichtungen zur Abgabe der analogen Signale ergeben, nach Art einer Lernfunktion selbsttätig ausgeglichen bzw. eliminiert werden können; zweckmäßigerweise wird dabei im Sinne einer gewünschten gezielten Regelträgheit vorgesehen, daß der erste Referenzschwellwert bzw. der zweite Referenzschwellwert jeweils innerhalb eines Schwellwertbereiches mit einer oberen und einer unteren Bereichsgrenze liegen und somit die zuvor beschriebene Nachführung der Erkennungsgrenzen aufgrund von Änderungen durch Störeinflüsse erst dann wirksam wird, wenn erkannt wird, daß sich die Analogsignale tendenziell in Richtung der einen oder anderen Bereichsgrenze verschieben.

Um die Streuungen der für die Abgabe der analogen Eingangssignale verantwortlichen Serien-Bauteile bzw. deren Einbautoleranzen berücksichtigen zu können, ist vorgesehen, zumindest die AUS-Referenzschwellwerte bzw. die Bereichsgrenzen der zugehörigen Schwellwertbereiche vor dem ersten Gebrauch einmalig jeweils in einem Initialisierungsvorgang aufgrund der maximalen und minimalen Werte, insbesondere Amplituden, von zuvor erfaßten AUS-Analogsignalen einer jeden Betätigungsvorrichtung festzulegen. Dazu werden zumindest die analogen Signale, insbesondere pulsweisen Spannungsamplituden, die den Zuständen "AUS" entsprechen, in einen Speicher eingelesen und dort abgelegt. Diese eingelesenen Werte dienen dann als Grundlage für die erstmalige Festlegung der diesen Signalen zugeordneten Referenzschwellwerten bzw. Bereichsgrenzen der Schwellwertbereiche und stellen somit die Bedingungen her, die den späteren Einsatzbedingungen entsprechen. In besonders aufwandsarmer Weise können anstelle einer besonderen entsprechenden Initialisierung dann die EIN-Referenzschwellwerte bzw. die zugehörigen Schwellwertbereiche beim erstmaligen Definieren jeweils zum zuvor definierten AUS-Referenzschwellwert in einem festen und für sämtliche Signalgeber einer Betätigungsvorrichtung gleichen Störabstand a festgelegt werden, der als Erfahrungswert der Bauteile- bzw. Einbautoleranzen gewonnen wurde. Eine optimale individuelle Anpassung erfolgt dann im Rahmen der anschließenden betriebsmäßigen Nachführung, die sowohl für die AUS-Analogsignale als auch für die EIN-Analogsignale unabhängig voneinander erfolgt. Dabei ist darauf zu achten, daß sowohl dem Zustand "EIN" als auch dem Zustand "AUS" von 0 unterschiedliche Signalwerte entsprechen.

Die Erfindung sowie weitere vorteilhafte Ausgestaltungen der Erfindung werden im folgenden anhand schematischer Ausführungsbeispiele, insbesondere in Anwendung auf mehrere Tastenelemente in Form von optoelektronischen Berührungssensoren für eine elektronische Kochstellensteuerung beschrieben; darin zeigen:
- FIG 1: den grundsätzlichen Aufbau einer elektronischen Kochstellensteuerung;
- FIG 2: ein einzelnes pulsförmiges EIN/AUS-Analogsignal mit Referenzschwellwerten für "EIN" bzw."AUS";
- FIG 3: ein einzelnes pulsförmiges EIN/AUS-Analogsignal mit jeweils einem EIN-Referenzschwellwert und einem AUS-Referenzschwellwert und mit einem diesen jeweils mit einer oberen Bereichsgrenze und einer unteren Bereichsgrenze übergreifenden Schwellwertbereich;
- FIG 4: die beispielhafte Verteilung von Referenzschwellwerten bzw. Schwellwertbereichen für sechs Tastenelemente eines Tastenfeldes einer elektronischen Kochstellensteuerung;
- FIG 5: den Ablauf einer Auswertung eines EIN/AUS-Analogsignals im Sinne einer Nachführung der Referenzschwellwerte an eine tendenzielle, z.B. alterungsbedingte, Änderung der Amplituden der Analogsignale;
- FIG 6: den Zusammenhang zwischen dem jeweiligen Status eines Tastenelementes mit jeweils entsprechendem Spannungs-Analogeingangssignal einerseits und einer Zuordnung zu einem "EIN"-Filter bzw. zu einem "AUS"-Filter.

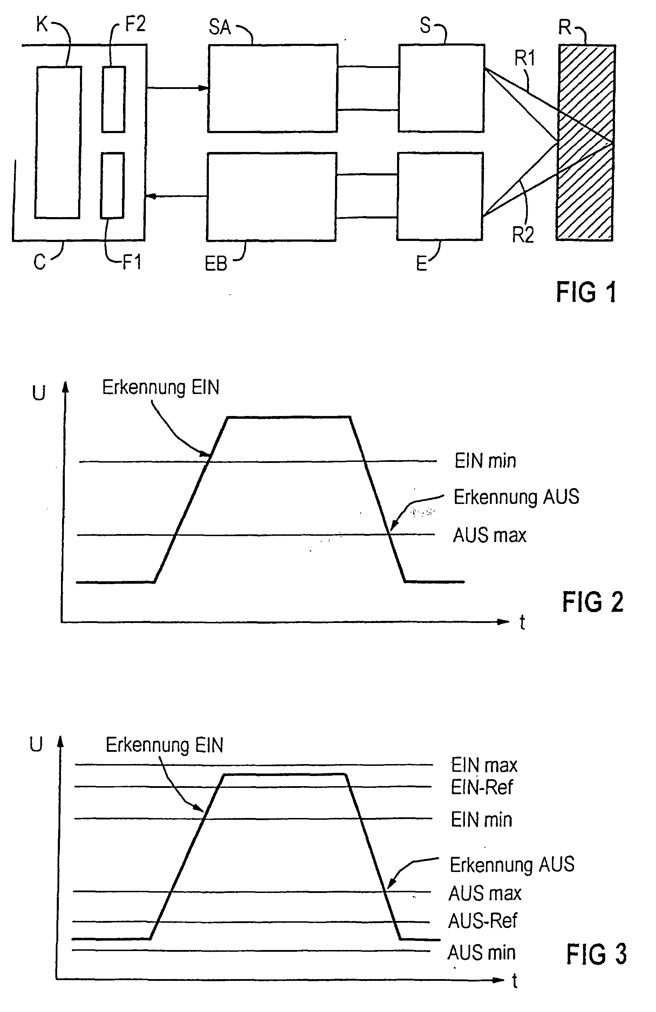

FIG 1 zeigt den Prinzipaufbau einer optoelektronischen Kochstellensteuerung mit einer berührungsempfindlichen Infrarot-Reflexlichtschranke; dazu wird von einem elektronischen Controller C über eine Sender-Ansteuerung SA ein Sender S, insbesondere eine im Pulsbetrieb arbeitende Infrarot-Leuchtdiode (IR-LED) zyklisch angesteuert. Die Infrarotlichtimpulse des Senders S treffen auf eine Glasfläche R, insbesondere die Ceranfläche einer Kochstelle, und werden von dieser bei nichtbetätigtem Berührungssensor im wesentlichen nur als Streulicht-Reflexionsstrahl R2 aufgrund einer inneren Reflexion zu einem Empfänger E, insbesondere einem Infrarotempfänger, mit einer nachfolgenden Empfänger-Beschaltung EB reflektiert. Erst wenn die äußere Berührungsfläche der Glasfläche R gezielt, z.B. durch Auflegen eines Betätigungsfingers, bedeckt wird, kommt es zu einem Nutzlicht-Reflexionsstrahl R1, der das Streulichtsignal derart in seiner Amplitude übersteigt, daß in einem Komparator K, der zweckmäßigerweise in der elektronischen Baueinheit des Controllers C integriert ist, ein EIN-Analogsignal identifizierbar ist.

FIG 2,3 zeigen qualitativ den Verlauf der an den Komparator K gelangenen analogen Eingangsspannung eines Pulses bei Betätigung eines der Tastenelemente T1-T6 der elektronischen Kochstellensteuerung. Wie z.B. anhand von FIG 2 verdeutlicht, muß zum Erkennen des Zustandes "EIN" bei Betätigung des jeweiligen Tastenelementes T1-T6 ein Signalpegel EINmin überschritten und zum Erkennen des Zustandes "AUS" nach Loslassen der Betätigung des Tastenelementes ein Signalpegel AUSmax unterschritten werden. Dadurch wird eine Hysterese eingestellt, die das Schaltverhalten des Tastenelementes definiert.

FIG 3 zeigt bei dem in FIG 2 angenommenen qualitativen Verlauf der analogen Eingangsspannung und den zuvor beschriebenen Erkennungsgrenzen die Festlegung eines Referenzschwellwertes EIN-Ref sowie eines Referenzschwellwertes AUS-Ref und entsprechender Schwellwertbereiche mit jeweils einer oberen Bereichsgrenze EINmax bzw. AUSmax und einer unteren Schwellwertgrenze EINmin bzw. AUSmin.

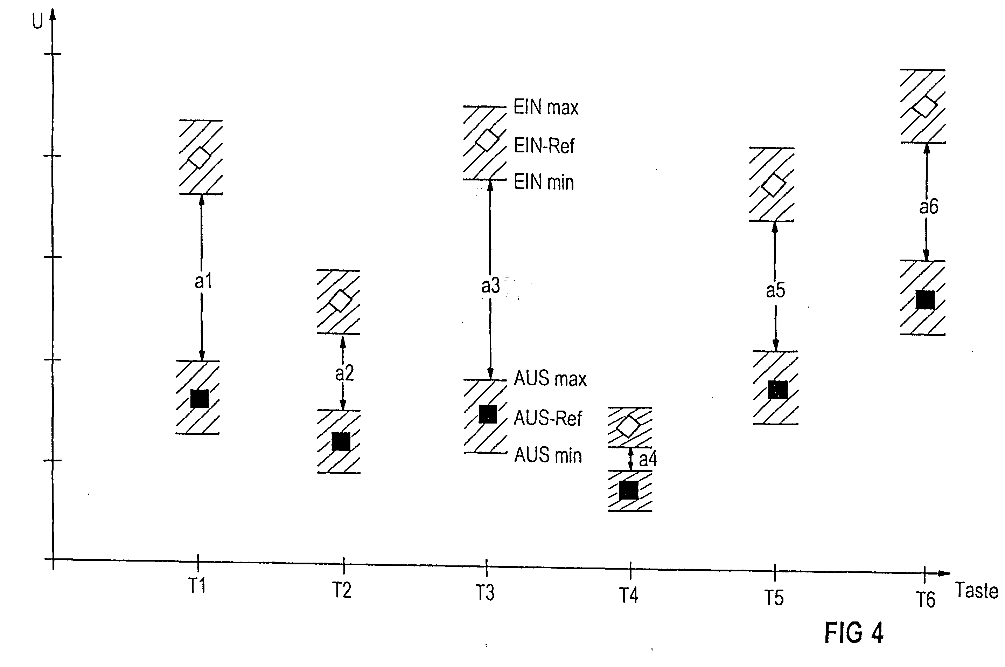

FIG 4 zeigt das Beispiel einer Verteilung von toleranzbedingt unterschiedlichen Referenzschwellwerten bzw. Schwellwertbereichen verteilt über sechs Tastenelemente T1-T6 einer elektronischen Kochstellensteuerung.

Die vorgenannten Referenzschwellwerte bzw. Schwellwertbereiche mit jeweils einer oberen und einer unteren Bereichsgrenze werden für jedes einzelne Tastenelement T1-T6 vor dem ersten Gebrauch einmalig durch Einlesen, Auswerten und anschließendes Ablegen der EIN/AUS-Analogsignale als Referenz in dem Controller C individuell bestimmt. Dabei wird - wie aus FIG 4 ersichtlich - jeweils zwischen der unteren Bereichsgrenze des oberen EIN-Schwellwertbereiches und der oberen Bereichsgrenze des unteren AUS-Schwellwertbereiches ein Mindeststörabstand (a1-a6) sichergestellt. Die Unterschiede in den entsprechenden analogen Spannungssignalen ergeben sich dabei insbesondere aufgrund von Bauteiletoleranzen der verwendeten Infrarot-Sender bzw. Infrarot-Empfänger sowie deren Einbautoleranzen, die z.B. die Strahlstärke des Senders beeinflussen können.

Die Initalisierung kann - falls z.B. Erfahrungswerte für diese Toleranzen vorliegen - dadurch vereinfacht werden, daß die EIN-Referenzwerte nicht gesondert durch Einlesen der EIN-Analogsignale ermittelt sondern lediglich in erfahrungsbedingtem einheitlichen Abstand zum jeweils durch Verarbeiten von zuvor erstmalig eingelesenen AUS-Analogsignalen AUS-Referenzwert festgelegt werden. Eine je Tastenelement T1-T6 individuelle Abstandsfestlegung kann dann in der anschließenden selbsttätigen Nachführung für jedes Tastenelement erfolgen.

Nachdem in einem Initialisierungsvorgang die Referenzschwellwerte bzw. Bereichsgrenzen der Schwellwertbereiche jeweils aufgrund der vor Inbetriebnahme erfaßten maximalen und minimalen Werte der EIN-Analogsignale bzw. zumindest der AUS-Analogsignale festgelegt worden sind, erfolgt im eigentlichen nachfolgenden Betriebseinsatz die Nachführung der Referenzschwellwerte bzw. der Schwellwertbereiche aufgrund eines sukzessiven Vergleichs von nach dem erstmaligen Initialisierungsvorgang in festlegbaren zeitlichen Überwachungsabständen jeweils erfaßten EIN-Analogsignalen bzw. AUS-Analogsignalen.

Dazu werden in weiterer Minderung des Ansteuerungs- bzw. Meßaufwandes nach einer Ausgestaltung der Erfindung sämtliche jeweils von verschiedenen Tastenelementen T1-T6 und jeweils verschiedenen Empfängern E bzw. Sendern S gelieferten EIN/AUS-Analogsignale in einem einzigen Komparator derart erfaßt und verglichen, daß die verschiedenen Empfänger bzw. Sender sukzessiv, insbesondere zyklisch, in Überwachungsabhängigkeit mit dem Komparator K gestellt werden; dadurch erfolgt nach Art einer Lernfunktion eine Anpassung an Änderungstendenzen der Analogsignale aufgrung insbesondere von Alterungs- bzw. Temperatureinflüssen.

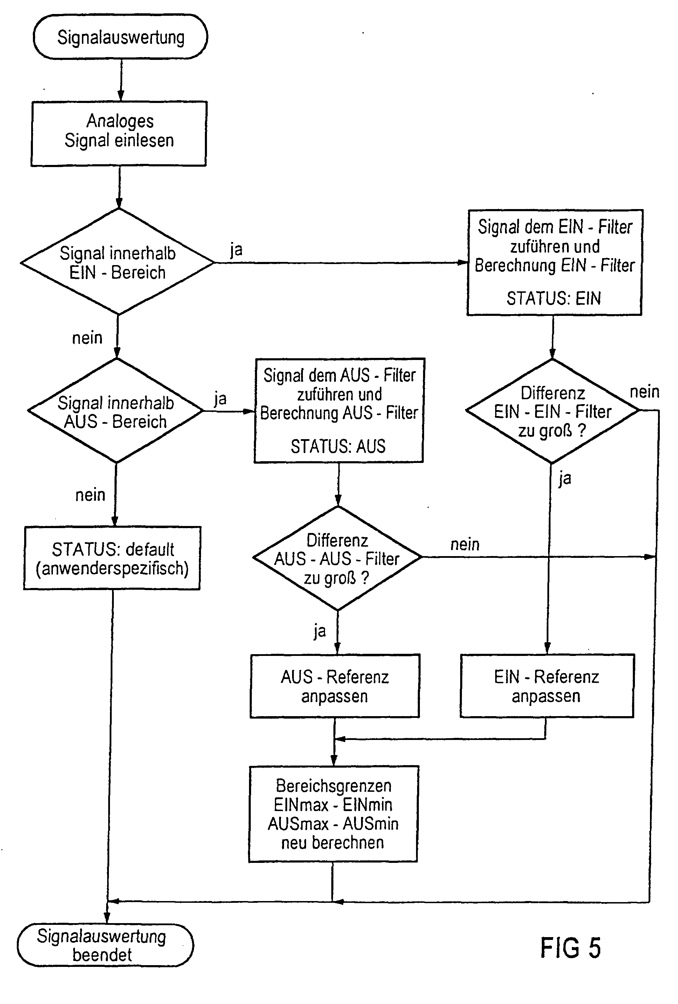

Wie insbesondere aus dem Verfahrensablauf einer Signalauswertung gemäß FIG 5 ersichtlich, werden während der zeitlichen Überwachungsabstände die EIN-Analogsignale bzw. AUS-Signale des jeweiligen Tastenelementes T1-T6 im Sinne einer zeitlichen Integration in jeweils einen Speicher eingelesen, der im Sinne eines auf die Amplituden der EIN-Analogsignale bzw. auf die Amplituden der AUS-Analogsignale abgestimmten jeweiligen Tiefpasses T1 bzw.T2 ausgebildet ist. Die erfindungsgemäße Nachführung der Referenzschwellwerte bzw. Schwellwertbereiche je Tastenelement erfolgt zweckmäßigerweise aufgrund des Überschreitens einer festlegbaren Mindestdifferenz zwischen den Referenzschwellwerten bzw. Bereichsgrenzen der Schwellwertbereiche jeweils dann, wenn eine Abweichungs-Mindestdifferenz gegenüber der beim Initialiserungsvorgang oder bei einem vorherigen Überwachungsvorgang festgelegten Referenzwerte zu erwarten ist. Dabei bleiben bei Berechnung der Mindestdifferenz zweckmäßigerweise Analogsignale, die im Überwachungszeitraum außerhalb des jeweiligen zugehörigen Schwellwertbereiches liegen, unberücksichtigt. Auf diese Art und Weise werden die Bereichsgrenzen oberhalb und unterhalb der jeweils aktuellen Referenzschwellwerte, in denen ein Schaltzustand "EIN" bzw. Schaltzustand "AUS" erkannt wird, aufgrund der aktuellen Werte der eingehenden analogen EIN-Signale bzw. analogen AUS-Signale nachgeführt.

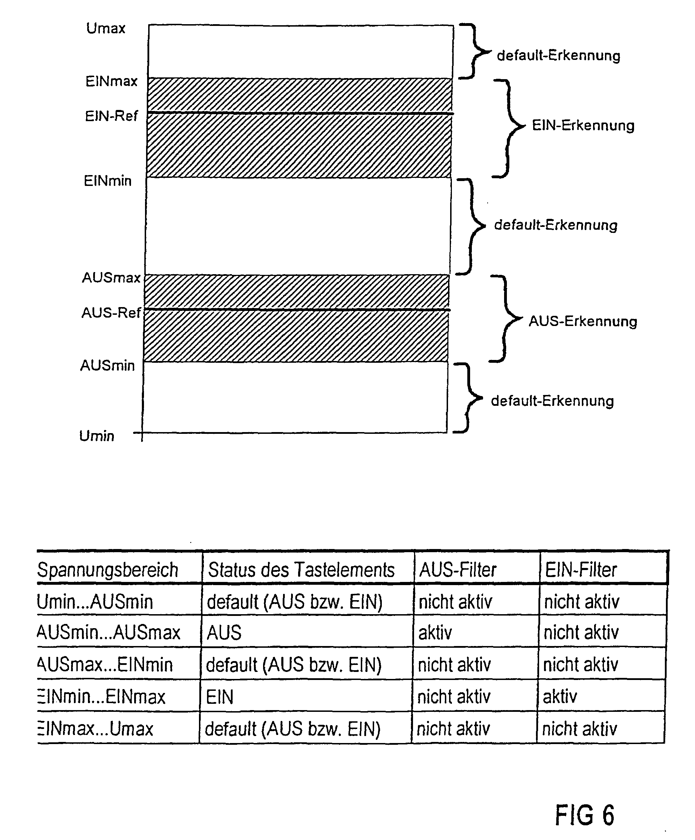

FIG 6 zeigt zur Verdeutlichung ausgehend von für ein einziges Tastenelement festgelegten Schwellwertbereichen die Zuordnung von verschiedenen eingangsseitigen Spannungssignalwerten eines Tastenelementes zu einem jeweiligen Status dieses Tastenelementes und zu einem zugehörigen "AUS"-Filter bzw. "EIN"-Filter, in den in den Überwachungsabständen die eingehenden EIN-Analogsignale bzw. AUS-Analogsignale eingelesen worden sind.

Es dürfte ersichtlich sein, daß durch das kontinuierliche selbsttätige Nachführen der Referenzschwellwerte bzw. Schwellwertbereiche im Sinne einer Lernfunktion das Schaltverhalten jedes einzelnen Tastenelementes im Laufe der Betriebszeit immer präziser und störungssicherer wird, da sich die Schwellwerte bzw. Schwellwertbereiche den spezifischen Betriebsbedingungen (Bauelemente, Einbaulage, Alterung, Temperatur, Bedienverhalten des Benutzers) anpassen können, nachdem vor dem ersten Gebrauch in einem Initialisierungsvorgang die analogen Signale zumindest für "AUS" eingelesen und entsprechende Referenzwerte für EIN-Ref bzw. AUS-Ref definiert worden sind.

## Patentansprüche

1. Verfahren zur Umwandlung von, insbesondere zueinander amplitudendifferenten, EIN/AUS-Analogsignalen in entsprechende EIN/AUS-Digitalsignale bei Erreichen eines jeweils spezifischen, einem Komparator (K) vorgebbaren EIN-Referenzschwellwertes oder AUS-Referenzschwellwertes, insbesondere eines jeweiligen Amplituden-Referenzschwellwertes, mit folgenden Merkmalen:
a) Dem Komparator (K) wird für die EIN-Analogsignale eines Signalgebers ein erster, ein EIN-Analogsignal erkennender Referenzschwellwert (EIN-Ref) zugeordnet;
b) dem Komparator (K) wird für die AUS-Analogsignale eines Signalgebers ein zweiter, ein AUS-Analogsignal erkennender, insbesondere gegenüber dem ersten pegelniedrigerer, Referenzschwellwert (AUS-Ref) zugeordnet;
c) der erste Referenzschwellwert (EIN-Ref) ist in Nachführabhängigkeit von den absoluten Werten, insbesondere Amplitudenwerten, des jeweiligen EIN-Analogsignals gestellt;
d) der zweite Referenzschwellwert (AUS-Ref) ist in Nachführabhängigkeit von den absoluten Werten, insbesondere Amplitudenwerten, des jeweiligen AUS-Analogsignals in Nachführbarabhängigkeit gestellt;
e) der erste Referenzschwellwert (EIN-Ref) wird im Sinne eines gewährleisteten Störabstandes (a) von dem zweiten Referenzschwellwert (AUS-Ref) beabstandet;
f) der erste Referenzschwellwert (EIN-Ref) und der zweite Referenzschwellwert (AUS-Ref) liegt jeweils innerhalb eines Schwellwertbereiches mit einer oberen und einer unteren Bereichsgrenze (EINmax;ElNmin; AUSmax;AUSmin);
j) die Nachführung der Referenzschwellwerte und/oder der Schwellwertbereiche erfolgt aufgrund eines sukzessiven Vergleiches von nach einem erstmaligen Initialisierungsvorgang in festlegbaren zeitlichen Überwachungsabständen jeweils erfassten EIN-Analogsignalen und AUS-Analogsignalen.

2. Verfahren nach Anspruch 1 mit dem Merkmal:
g) Zumindest der zweite Referenzschwellwert (AUS-Ref) und/oder die Bereichsgrenzen des zugehörigen Schwellwertbereiches werden in dem Initialisierungsvorgang aufgrund der maximalen und minimalen Werte, insbesondere Amplituden, von zuvor erfassten AUS-Analogsignalen festegelegt.

3. Verfahren nach Anspruch 2 mit dem Merkmal:
h) Der erste Referenzschwellwert (EIN-Ref) und/oder die Bereichsgrenzen des zugehörigen Schwellwertbereiches werden in einem definierten Störabstand (a) zu dem zweiten Referenzschwellwerte (AUS-Ref) und/oder dem zugehörigen Schwellwertbereich festgelegt.

4. Verfahren nach Anspruch 2 mit dem Merkmal:
i) Der erste Referenzschwellwert (EIN-Ref)und der zweite Referenzschwellwert (AUS-Ref) und/oder die Bereichsgrenzen der jeweiligen Schwellwertbereiche werden in dem Initialisierungsvorgang jeweils aufgrund der maximalen und minimalen Werte, insbesondere Amplituden, von zuvor erfassten EIN-Analogsignalen und AUS-Analogsignalen festgelegt.

5. Verfahren nach einem der vorhergehenden Ansprüche mit dem Merkmal:
k) Die, insbesondere pulsförmigen, EIN-Analogsignale und AUS-Analogsignale werden während der zeitlichen Überwachungsabstände im Sinne einer zeitlichen Integration in einen Speicher eingelesen.

6. Verfahren nach Anspruch 5 mit dem Merkmal:
I) Den EIN-Analogsignalen und/oder den AUS-Analogsignalen ist jeweils ein spezifischer Filter, insbesondere Amplitudenfilter, im Sinne eines jeweils abgestimmten Tiefpasses zugeordnet.

7. Verfahren nach Anspruch 6 mit dem Merkmal:
m) Die Nachführung erfolgt aufgrund des Überschreitens einer festlegbaren Mindestdifferenz zwischen den Referenzschwellwerten und/oder den Schwellwertbereichen aufeinanderfolgender Überwachungsabstände.

8. Verfahren nach Anspruch 7 mit dem Merkmal:
n) Bei der Berechnung der Mindestdifferenz bleiben Analogsignale, insbesondere Amplituden, die im Überwachungszeitraum außerhalb des jeweiligen zugehörigen Referenzschwellwertes und/oder Schwellwertbereiches liegen, unberücksichtigt.

9. Verfahren nach zumindest einem der vorhergehenden Ansprüche mit den Merkmalen:
o) Eine Betätigungsvorrichtung enthält mehrere Signalgeber mit jeweils individuellen EIN/AUS-Analogsignalen;
p) den EIN-Analogsignalen und/oder AUS-Analogsignalen eines jeden Signalgebers ist je ein erster Referenzschwellwert (EIN-Ref) und je ein zweiter Referenzschwellwert (AUS-Ref) und/oder je ein entsprechender Schwellwertbereich zugeordnet.

10. Verfahren nach Anspruch 3 oder 9 mit dem Merkmal:
q) Die ersten Referenzschwellwerte (EIN-Ref) sämtlicher Signalgeber werden bei dem Initialisierungsvorgang mit dem gleichen Störabstand zu dem je Signalgeber individuell ermittelten zweiten Referenzschwellwert (AUS-Ref) beabstandet.

11. Verfahren nach einem der vorhergehenden Ansprüche mit dem Merkmal:
r) Mehrere, jeweils von verschiedenen Empfängem und/oder Gebern gelieferte Ein/Aus-Analogsignale sind einem einzigen Komparator (K) zugeordnet;
s) die verschiedenen Signalgeber werden sukzessiv, insbesondere zyklisch, in Überwachungsabhängigkeit mit dem Komparator (K) gestellt.

12. Verfahren nach einem der vorhergehenden Ansprüche mit dem Merkmal:
t) Die Ein-Analogsignale und Aus-Analogsignale werden jeweils von Signalgebern einer Kochstellensteuerung eines Herdes, insbesondere von je einem mehrerer Tastenelemente (T1-T6) mit je einer berührungsempfindlichen infrarot-Reflexlichtschranke, abgegeben.

## Claims

1. Method of converting ON/OFF analog signals, which are, in particular, different from one another in amplitude, into corresponding ON/OFF digital signals on reaching a respective specific ON reference threshold value or OFF reference threshold value predeterminable by a comparator (K), particularly a respective amplitude reference threshold value, with the following features:
a) a first reference threshold value (ON-Ref), which recognises an ON analog signal, is associated with the comparator (K) for the ON analog signals of a signal transmitter;
b) a second reference threshold value (OFF-Ref), which recognises an OFF analog signal and is, in particular, lower in level relative to the first threshold reference value, is associated with the comparator (K) for the OFF analog signals of the signal transmitter;
c) the first reference threshold value (OFF-Ref) is set in tracking dependence on the absolute values, in particular amplitude values of the respective ON analog signal;
d) the second reference threshold value (OFF-Ref) is set in tracking dependence on the absolute values, in particular amplitude values, of the respective OFF analog signal;
e) the first reference threshold value (ON-Ref) is spaced from the second reference threshold value (OFF-Ref) in the sense of a guaranteed signal-to-noise ratio (a);
f) the first reference threshold value (ON-Ref) and the second reference threshold value (OFF-Ref) respectively lie within a threshold value range with an upper and a lower range limit (ONmax; ONmin; OFFmax; OFFmin); and
j) the tracking of the reference threshold values and/or the threshold value ranges takes place on the basis of a successive comparison of ON analog signals and OFF analog signals respectively detected at monitoring intervals, which are fixable in terms of time, after a first-time initialisation process.

2. Method according to claim 1, with the feature:
g) at least the second reference threshold value (OFF-Ref) and/or the range limits of the associated threshold value range are established in the initialisation process on the basis of the maximum and minimum values, in particular amplitudes, of previously detected OFF analog signals.

3. Method according to claim 2, with the feature:
h) the first reference threshold value (ON-Ref) and/or the range limits of the associated threshold value range are established at a defined signal-to-noise ratio (a) with respect to the second reference threshold value (OFF-Ref) and/or the associated threshold value range.

4. Method according to claim 2, with the feature:
i) the first reference threshold value (ON-Ref) and the second reference threshold value (OFF-Ref) and/or the range limits of the respective threshold value ranges are established in the initialisation process respectively on the basis of the maximum and minimum values, particularly amplitudes, of previously detected ON analog signals and OFF analog signals.

5. Method according to one of the preceding claims with the feature:
k) the ON analog signals and OFF analog signals, which are, in particular, pulse-shaped, are read into a memory during the temporal monitoring intervals in the sense of an integration in time.

6. Method according to claim 5, with the feature:
I) a respective specific filter, in particular an amplitude filter, in the sense of a respectively tuned low-pass filter is associated with the ON analog signals and/or the OFF analog signals.

7. Method according to claim 6, with the feature:
m) the tracking is carried out on the basis of exceeding a fixable minimum difference between the reference threshold values and/or the threshold value ranges of successive monitoring intervals.

8. Method according to claim 7, with the feature:
n) analog signals, particularly amplitudes, which lie outside the respectively associated reference threshold value and/or threshold value range in the monitoring time period are left out of consideration in the calculation of the minimum difference.

9. Method according to at least one of the preceding claims with the features:
o) an actuating device comprises several signal transmitters each with individual ON/OFF analog signals;
p) a respective first reference threshold value (ON-Ref) and a respective second reference threshold value (OFF-Ref) and/or a respective corresponding threshold value range is or are associated with the ON analog signals and/or OFF analog signals.

10. Method according to claim 3 or 9, with the feature:
q) the first reference threshold values (ON-Ref) of all signal transmitters are during the initialisation process spaced at the same signal-to-noise ratio with respect to the second reference threshold value (OFF-Ref) individually determined per signal transmitter.

11. Method according to one of the preceding claims, with the feature:
r) several ON/OFF analog signals respectively delivered by different receivers and/or transmitters are associated with a single comparator (K); and
s) the different signal transmitters are successively, in particular cyclically, set in monitoring dependence with the comparator (K).

12. Method according to one of the preceding claims, with the feature:
t) the ON analog signals and OFF analog signals are respectively delivered by signal transmitters of a cooking place control of an oven, in particular by a respective one of several button elements (T1 to T6), each with a respective contact-sensitive infrared reflected light barrier.

## Revendications

1. Procédé de conversion de signaux analogiques d'entrée / sortie, en particulier ayant des amplitudes différentes relativement, en signaux d'entrée / sortie numériques correspondants, une valeur seuil de référence d'entrée ou une valeur seuil de référence de sortie respectivement spécifique pouvant être prescrite(s) à un comparateur (K), et plus particulièrement une valeur seuil de référence d'amplitude respective, étant atteinte, présentant les caractéristiques suivantes:
a) une première valeur seuil de référence (réf ENTRÉE) identifiant un signal analogique d'entrée est affectée au comparateur (K) pour les signaux analogiques d'entrée d'une source de signaux;
b) une deuxième valeur seuil de référence (réf SORTIE) identifiant un signal analogique de sortie et en particulier étant de niveau inférieur par rapport à la première, est affectée au comparateur (K) pour les signaux analogiques de sortie d'une source de signaux;
c) la première valeur seuil de référence (réf ENTRÉE) est mise en dépendance de poursuite par rapport aux valeurs absolues, en particulier aux valeurs d'amplitudes, du signal analogique d'entrée respectif;
d) la deuxième valeur seuil de référence (réf SORTIE) est mise en dépendance de poursuite par rapport aux valeurs absolues, en particulier aux valeurs d'amplitudes, du signal analogique de sortie respectif;
e) la première valeur seuil de référence (réf ENTRÉE) est située à distance de la deuxième valeur seuil de référence (réf SORTIE) au sens d'un rapport signal / bruit (a) garanti;
f) la première valeur seuil de référence (réf ENTRÉE) et la deuxième valeur seuil de référence (réf SORTIE) se trouvent respectivement à l'intérieur d'une plage de valeur seuil avec une limite de plage supérieure et une limite de plage inférieure (ENTRÉEmax; ENTRÉEmin; SORTIEmax; SORTIEmin);
j) la poursuite des valeurs seuils de référence et/ou des plages de valeur seuil se fait sur la base d'une comparaison successive de signaux analogiques d'entrée et de signaux analogiques de sortie respectivement saisis après une première opération d'initialisation à des intervalles temporels de surveillance déterminables.

2. Procédé selon la revendication 1, présentant la caractéristique:
g) au moins la deuxième valeur seuil de référence (réf SORTIE) et/ou les limites de plage de la plage de valeur seuil associée sont déterminées dans l'opération d'initialisation sur la base des valeurs maximales et minimales, et plus particulièrement des amplitudes, de signaux analogiques de sortie saisis préalablement.

3. Procédé selon la revendication 2, présentant la caractéristique:
h) la première valeur seuil de référence (réf ENTRÉE) et/ou les limites de plage de la plage de valeur seuil associée sont déterminées à un rapport signal / bruit (a) défini par rapport à la deuxième valeur seuil de référence (réf SORTIE) et/ou à la plage de valeur seuil associée.

4. Procédé selon la revendication 2, présentant la caractéristique:
i) la première valeur seuil de référence (réf ENTRÉE) et la deuxième valeur seuil de référence (réf SORTIE) et/ou les limites de plage des plages de valeur seuil respectives sont déterminées dans l'opération d'initialisation respectivement sur la base des valeurs maximales et minimales, et plus particulièrement des amplitudes, de signaux analogiques d'entrée et de signaux analogiques de sortie saisis préalablement.

5. Procédé selon l'une des revendications précédentes, présentant la caractéristique:
k) les signaux analogiques d'entrée et les signaux analogiques de sortie, plus particulièrement impulsionnels, sont lus dans une mémoire au sens d'une intégration temporelle pendant les intervalles de surveillance temporels.

6. Procédé selon la revendication 5, présentant la caractéristique:
I) aux signaux analogiques d'entrée et/ou aux signaux analogiques de sortie est affecté respectivement un filtre spécifique, en particulier un filtre d'amplitude, au sens d'un passe-bas respectivement accordé.

7. Procédé selon la revendication 6, présentant la caractéristique:
m) la poursuite se fait sur la base du dépassement d'une différence minimale déterminable entre les valeurs seuils de référence et/ou les plages de valeur seuil d'intervalles de surveillance successifs.

8. Procédé selon la revendication 7, présentant la caractéristique:
n) des signaux analogiques, et plus particulièrement des amplitudes, qui se trouvent en dehors de la valeur seuil de référence et/ou de la plage de valeur seuil associée respective(s) pendant la période de surveillance ne sont pas pris en compte lors du calcul de la différence minimale.

9. Procédé selon au moins l'une des revendications précédentes, présentant les caractéristiques:
o) un dispositif d'actionnement contient plusieurs sources de signaux avec respectivement des signaux analogiques d'entrée / sortie individuels;
p) aux signaux analogiques d'entrée et/ou aux signaux analogiques de sortie de chaque source de signaux est affectée respectivement une première valeur seuil de référence (réf ENTRÉE) et respectivement une deuxième valeur seuil de référence (réf SORTIE) et/ou respectivement une plage de valeur seuil correspondante.

10. Procédé selon la revendication 3 ou 9, présentant la caractéristique:
q) les premières valeurs seuils de référence (réf ENTRÉE) de toutes les sources de signaux sont situées à distance, lors de l'opération d'initialisation, avec le même rapport signal / bruit par rapport à la deuxième valeur seuil de référence (réf SORTIE) déterminée individuellement pour chaque source de signaux.

11. Procédé selon l'une des revendications précédentes, présentant la caractéristique:
r) plusieurs signaux analogiques d'entrée / sortie, fournis respectivement par différents récepteurs et/ou sources, sont affectés à un unique comparateur (K);
s) les différentes sources de signaux sont mises successivement, et plus particulièrement cycliquement, en dépendance de surveillance avec le comparateur (K).

12. Procédé selon l'une des revendications précédentes, présentant les caractéristiques:
t) les signaux analogiques d'entrée et les signaux analogiques de sortie sont respectivement délivrés par des sources de signaux d'une commande d'endroits de cuisson d'une cuisinière, en particulier par respectivement l'un de plusieurs éléments servant de touches (T1- T6) avec respectivement une barrière infrarouge photoélectrique à réflexion de type tactile.
